(19) 

**Europäisches Patentamt**
**European Patent Office**
**Office européen des brevets**

(11) **EP 4 718 975 A1**

(12) **EUROPEAN PATENT APPLICATION**

(43) Date of publication:
**01.04.2026 Bulletin 2026/14**

(21) Application number: **25204912.7**

(22) Date of filing: **26.09.2025**

(51) International Patent Classification (IPC):
**H10D 8/01** *(2025.01)* **H10D 8/25** *(2025.01)*
**H10D 62/10** *(2025.01)* **H10D 64/00** *(2025.01)*

(52) Cooperative Patent Classification (CPC):
**H10D 8/25; H10D 8/022; H10D 62/126;
H10D 62/128; H10D 64/111**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **30.09.2024 US 202418902563**

(71) Applicant: **NXP B.V.**
**5656 AG Eindhoven (NL)**

(72) Inventors:
• **Mehrotra, Saumitra Raj**
**5656AG Eindhoven (NL)**
• **Cheng, Xu**
**5656AG Eindhoven (NL)**
• **Zhu, Ronghua**
**5656AG Eindhoven (NL)**

(74) Representative: **Krott, Michel**
**NXP Semiconductors**
**Intellectual Property Group**
**High Tech Campus 60**
**5656 AG  Eindhoven (NL)**

(54) **ZENER DIODE WITH IMPROVED STRESS IMMUNITY UTILIZING A POLY MESH**

(57)   A Zener diode includes a P+ anode, a poly mesh ring residing on the surface of the semiconductor substrate and surrounding the P+ anode, an N+ cathode residing opposite the poly mesh ring from the P+ anode, an outer spacer on an outer portion of the poly mesh ring adjacent the N+ cathode, and an inner spacer on an inner portion of the poly mesh ring adjacent to the P+ anode. The poly mesh ring may be a polysilicon layer residing upon a TEOS layer. The Zener diode may reside in a low dope N-well with a Zener junction including a N-well high region adjacent and below the P+ anode. The Zener diode may reside in a high dope N-well with a Zener junction including a P- structure formed in the high dope N-well in an upper portion of the semiconductor substrate and adjacent and surrounding the P+ anode.

**FIG. 3**

EP 4 718 975 A1

**Description**

## BACKGROUND OF THE INVENTION

FIELD OF THE INVENTION

This invention relates generally to Zener diodes, and more particularly to Zener diodes used as voltage references.

## DESCRIPTION OF RELATED ART

Zener diodes are two-terminal electronic devices that act as conventional diodes when forward-biased, i.e., with unidirectional conduction, but when reverse-biased above a certain threshold voltage, conduct in the reverse direction. The term "Zener diode" is traditionally applied to devices comprised of P-N junctions formed in conventional semiconductor materials, e.g., Silicon (Si), with Zener junctions that undergo avalanche breakdown at reverse bias voltages above a particular voltage, which is dependent upon construction of the Zener diode.

When a Zener diode is reverse-biased above a certain voltage, i.e., the Zener threshold voltage, generally above 5 V, for example, for Si-based devices, a sudden rise in reverse current occurs. Thus, when forward-biased, a Zener diode functions as an ordinary rectifier, but, when reverse-biased, exhibits a sharp break in its I-V behavior. A characteristic of Zener breakdown is that once conduction occurs under reverse-bias, the Zener breakdown voltage across the Zener diode remains essentially constant upon further increase of reverse current, up to a maximum allowable dissipation rating. Thus, Zener diodes find utility, inter alia, as voltage regulators, in voltage reference circuitry, and as overvoltage protectors.

In modern voltage reference circuity, to generate accurate reference voltages, it is required to have the Zener breakdown voltage be constant across all operating temperatures, over their lifetime, and across process variations. However, when integrated circuits containing Zener diodes are packaged, as they age, and as they are stressed over time due to thermal cycling, the Zener threshold voltage changes, affecting the accuracy of the voltage reference circuitry.

## BRIEF DESCRIPTION OF THE DRAWINGS

One or more embodiments are described by way of example with reference to the accompanying drawings, in which:

FIG. 1 is a block diagram illustrating an integrated circuit having voltage reference circuitry including a least one Zener diode implemented in accordance with embodiments of the present disclosure;
FIG. 2A is block diagram illustrating example usage of voltage reference circuitry including at least one Zener diode in accordance with embodiments of the present disclosure;
FIG. 2B is graph illustrating variation in Zener breakdown voltage over the lifetime of a Zener diode;
FIG. 3 is a diagrammatic top view of a Zener diode in accordance with embodiments of the present disclosure;
FIG. 4 is a diagrammatic cut away side view of the Zener diode of FIG. 3 according to various embodiments of the present disclosure;
FIG. 5 is a diagrammatic top view of a Zener diode array in accordance with embodiments of the present disclosure consistent with FIGs. 3 and 4;
FIG. 6 is a diagrammatic top view of a Zener diode in accordance with embodiments of the present disclosure;
FIG. 7 is a diagrammatic cut away side view of the Zener diode of FIG. 6 according to various embodiments of the present disclosure;
FIG. 8 is a diagrammatic top view of a Zener diode array in accordance with embodiments of the present disclosure consistent with FIGs. 6 and 7;
FIG. 9 is a flow chart illustrating a process for manufacturing a Zener diode of FIGs. 3 and 4 in accordance with various embodiments of the present disclosure;
FIGs. 10A, 10B and 10C are diagrammatic cut away side views of a Zener diode at particular manufacturing process steps in accordance with various embodiments of the present disclosure and consistent with FIG. 9; and
FIG. 11 is a flow chart illustrating a process for manufacturing a Zener diode of FIGs. 6 and 7 in accordance with various embodiments of the present disclosure.

## DETAILED DESCRIPTION

The present disclosure described improved structures and methods of formation of a Zener diode/Zener diode array in a silicon substrate. Each of these improved structures includes a raised polysilicon mesh ring (poly mesh ring) surrounding a P+ anode of the Zener diode. The raised poly mesh ring provides increased resistance to deformation of a packaged integrated circuit in which the Zener diodes are formed, thus providing a more uniform Zener breakdown voltage over the lifespan of the Zener diodes and among differing Zener diodes formed using a same manufacturing, packaging, mounting, and operation of the Zener diodes.

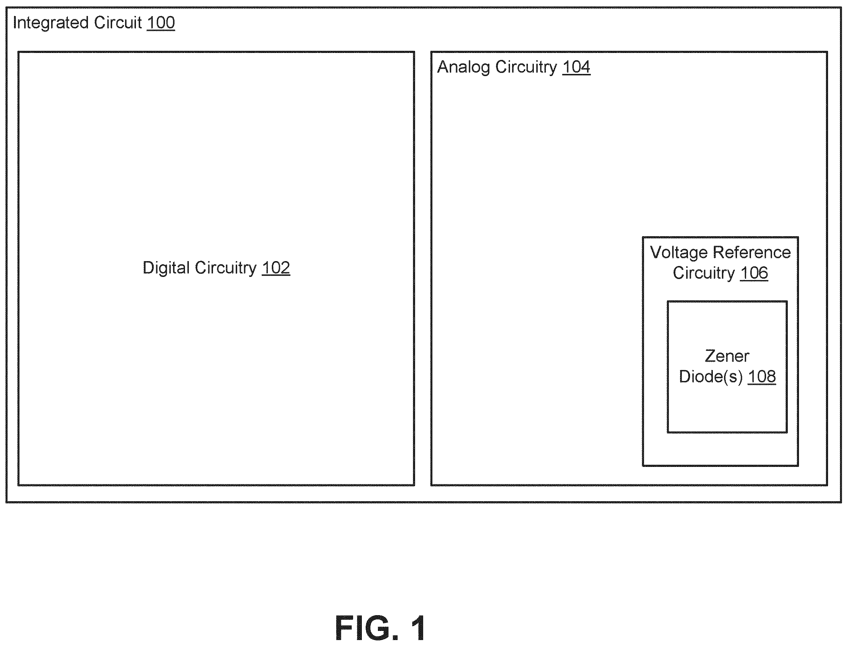

FIG. 1 is a block diagram illustrating an integrated circuit having voltage reference circuitry including at least one Zener diode implemented in accordance with embodiments of the present disclosure. The integrated circuit 100 is formed in a silicon substrate and includes digital circuitry 102 and analog circuitry 104. The analog circuitry 104 includes voltage reference circuitry 106, which includes one or more Zener diodes 108 according to embodiments of the present disclosure. These Zener diodes have nearly constant Zener breakdown voltages at all times, e.g., 5 V for Zener diodes formed on a silicon substrate, during operation to maintain constant reference voltages. If the reference voltage is not constant during all operations, portions of the analog circuitry 104 using the voltage reference circuitry 106 will have operational variance over time.

The integrated circuit 100 is packaged according to known techniques and may be installed in an electronic device, a vehicle, a sensor, an appliance, a lighting structure, or another type of device that includes the integrated circuit 100. A package in which the integrated circuit is contained may be a surface mount package, for example, that mounts upon a Printed Circuit Board (PCB). As is known, over its lifetime, the integrated circuit 100 will be subject to mechanical stresses due to thermal expansion differences between the integrated circuit 100, the package, and the PCB. When the integrated circuit 100 is packaged, when it is soldered to the PCB, and during its lifetime, the integrated circuit 100 will experience such mechanical stresses. Such mechanical stresses may may affect the Zener breakdown voltage of the Zener diodes 108 formed in the integrated circuit 100. Thus, Zener diodes constructed and manufactured according to embodiments described herein perform better than prior Zener diodes due to the poly mesh ring(s).

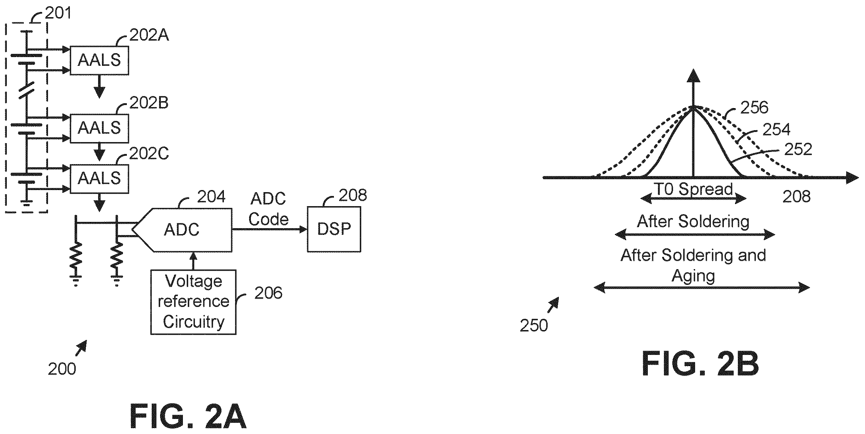

FIG. 2A is block diagram illustrating example usage of voltage reference circuitry including at least one Zener diode in accordance with embodiments of the present disclosure. The example embodiment of FIG. 2A is a battery cell controller 200 that may be present in an electric vehicle, a hybrid vehicle, a battery storage device, another device that includes one or more battery cells, or a battery cell characterization device.

The battery cell controller 200 includes a plurality of batteries coupled in series to form the battery cell 201. The overall voltage of the battery cell 201 may produce an overall voltage of 70 V, for example, with each battery having a respective voltage. Generally each battery of the battery cell 201 will have equal nominal voltage. The battery cell controller 200 further includes a plurality of analog amplifier level shifters (AALSs) 202A-202C, each coupled to a respective battery. Outputs of the AALS 202A-202C couple to a resistor network, e.g., differential resistor pair that produces an input to an Analog to Digital Converter (ADC) 204. The ADC 204 produces an ADC code output to a Digital Signal Processor 208, which calculates properties of the batteries of the battery cell 201. For example, during each sampling period, only one AALS 202 may couple to the ADC 204 so that the DSP 208 may determine properties of a respective coupled battery.

Voltage reference circuitry 206 produces a voltage reference signal to the ADC 204, which the ADC 204 uses in measuring voltage of a battery cell. The voltage reference circuitry 206 includes one or more Zener diodes formed and/or constructed according to one or more embodiments of the present disclosure, which produce more consistent Zener breakdown voltage over time and operation than prior Zener diodes.

FIG. 2B is graph illustrating variation in Zener breakdown voltage over the lifetime of a Zener diode. The graph 250 shows variation in Zener breakdown voltage over the life of the Zener diode, variations referred to as Zener breakdown voltage spread. Curve 252 illustrates variations in Zener breakdown voltage spread after initial calibration (T0). Curve 254 illustrates variations in Zener breakdown voltage spread after the integrated circuit is packaged and soldered to a PCB. Curve 256 illustrates variations in Zener breakdown voltage spread after soldering of the packaged to the PCB and aging. Such variations in Zener breakdown voltage spread become worse after soldering and soldering and aging than at calibration. Zener breakdown voltage spread improves significantly for Zener diodes constructed according to embodiments of the present disclosure than prior Zener diodes.

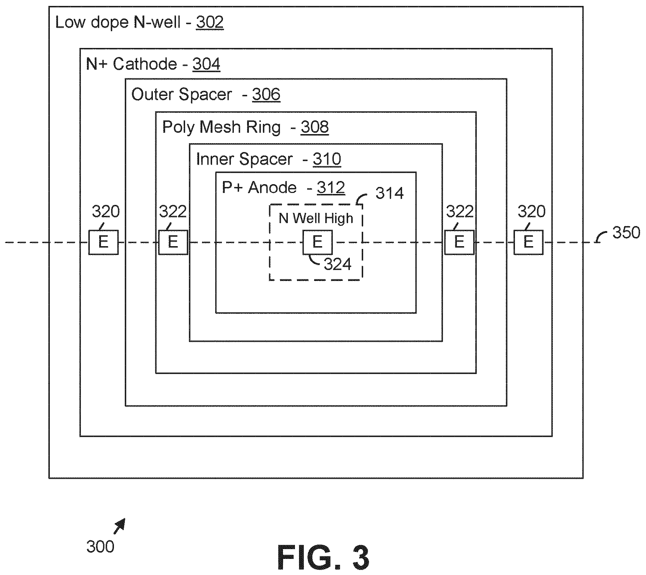

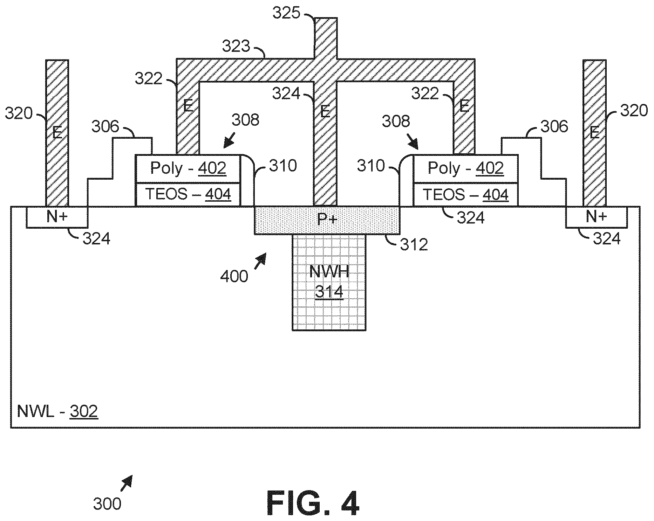

FIG. 3 is a diagrammatic top view of a Zener diode in accordance with embodiments of the present disclosure. FIG. 4 is a diagrammatic cut away side view of the Zener diode 300 of FIG. 3 according to various embodiments of the present disclosure. The structure illustrated in FIG. 4 is taken along reference line 350 of FIG. 3.

Referring to both FIG. 3 and FIG. 4, the Zener diode 300 is formed in a low dope N-well 302 of a semiconductor substrate. The Zener 300 diode includes a Zener junction 400 formed in the low dope N-well 302, the Zener junction 400 including a P+ anode 312. The P+ anode 312 is formed in an upper portion of the semiconductor substrate within the low dope N-23ll 302. An N-well high region 314 is formed in the low dope N-well 302, adjacent and below the P+ anode 312. The Zener diode 300 includes an N+ cathode 304 formed in the low dope N-well 302.

The Zener diode 300 further includes a poly mesh ring 308 formed on a surface of the semiconductor substrate and surrounding the Zener junction 400, which includes the P+ anode 312. The N+ cathode 304 is formed in the semiconductor substrate opposite the poly mesh ring 308 from the P+ anode 312. The Zener diode 300 further includes an outer spacer 306 formed on an outer portion of the poly mesh ring 308 between the N+ cathode 304 and the poly mesh ring 308. With the construct of the Zener diode 300, the N+ cathode 304 surrounds the poly mesh ring 308, separated from the poly mesh ring 308 by the outer spacer 306. The Zener diode 300 further includes an inner spacer 310 formed on an inner portion of the poly mesh ring 308 adjacent to the P+ anode 312.

With an optional construct of the illustrated embodiment, the width of the outer spacer 306 is greater than the width of the inner spacer 310. Further, with another optional construct of the Zener diode 300, the poly mesh ring 308 includes a polysilicon layer 402 residing upon a Tetraethyl Orthosilicate (TEOS) layer 404.

Moreover, with another optional construct of the Zener diode 300, the polysilicon layer 402 of the poly mesh ring 308 is electrically coupled to the P+ anode 312. The Zener diode 300 may include a plurality of electrical connections 320, 322, 323, 324 and 325. These electrical connections are one or more of vias and metal traces (formed in one or more metal routing layers, only 320, 322 and 324 shown in FIG. 3). Electrical connections 322, 323 and 324 electrically interconnect the polysilicon layer 402 of poly mesh ring 308 and the P+ anode 312. This optional construct provides additional reduction in the variation of the Zener breakdown voltage over operating conditions and time.

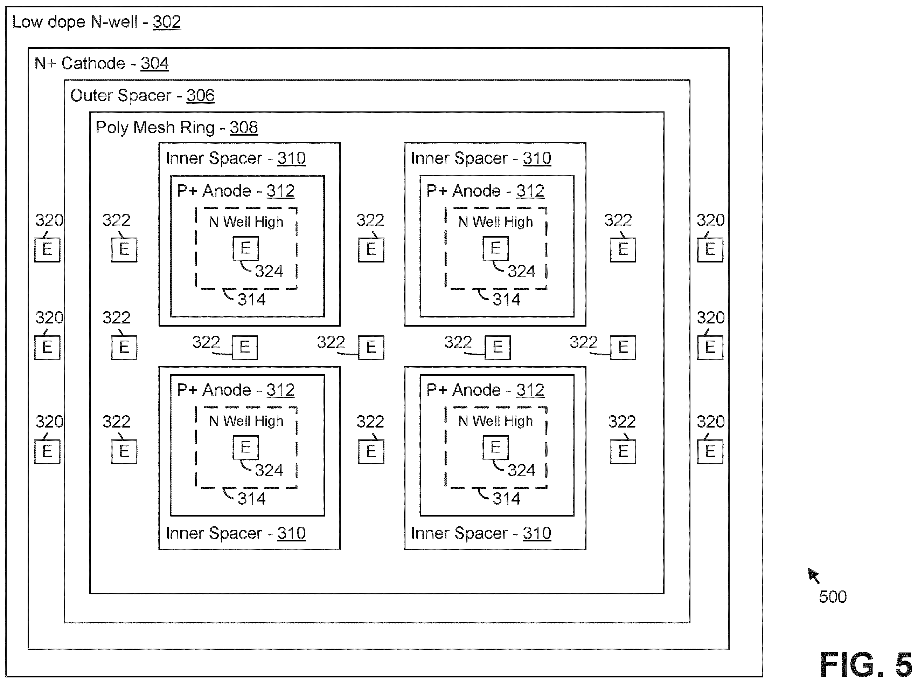

FIG. 5 is a diagrammatic top view of a Zener diode array in accordance with embodiments of the present disclosure consistent with FIGs. 3 and 4. The Zener diode array 500 includes a plurality of Zener junctions 400 formed in a semiconductor substrate as an array, each Zener junction including a P+ anode 312 formed in a low dope N-well 302. Each of the Zener junctions 400 is consistent with FIGs. 3 and 4 as are other components of the Zener diode array 500. The Zener diode array 500 also includes a poly mesh ring 308 formed on a surface of the semiconductor substrate, the poly mesh ring 308 surrounding each of the plurality of Zener junctions 400 (and P+ anodes 312).

The Zener diode array 500 further includes an N+ cathode 304 formed in the low dope N-well 302 of the semiconductor substrate opposite the poly mesh ring 308 from the P+ anodes 312. As is shown in FIG. 5, the N+ cathode 304 surrounds the poly mesh ring 308. The Zener diode array 500 further includes an outer spacer 306 formed on an outer portion of the poly mesh ring 308 isolating the poly mesh ring 308 from the N+ cathode 304. The Zener diode array 500 further includes a plurality of inner spacers 310, each inner spacer formed on an inner portion of the poly mesh ring 308, surrounding and adjacent a respective P+ anode 312. Each Zener junction 400 includes the P+ anode 312 formed in the low dope N-well 302 in an upper portion of the semiconductor substrate and a N-well high region 314 formed in the low dope N-well 302, adjacent and below the P+ anode 312.

With one construct of the Zener diode array, the poly mesh ring 308 includes a polysilicon layer residing upon a TEOS layer, with the polysilicon layer optionally electrically coupled to at least one P+ anode 312. Refer to FIG. 4 for the electrical connections for tying a P+ anode 312 to the polysilicon layer of the poly mesh ring 308 and the construct of the electrical connections. The Zener diode array may be NxN array, where N is a positive integer or an NxM array, where each of N and M are positive integers.

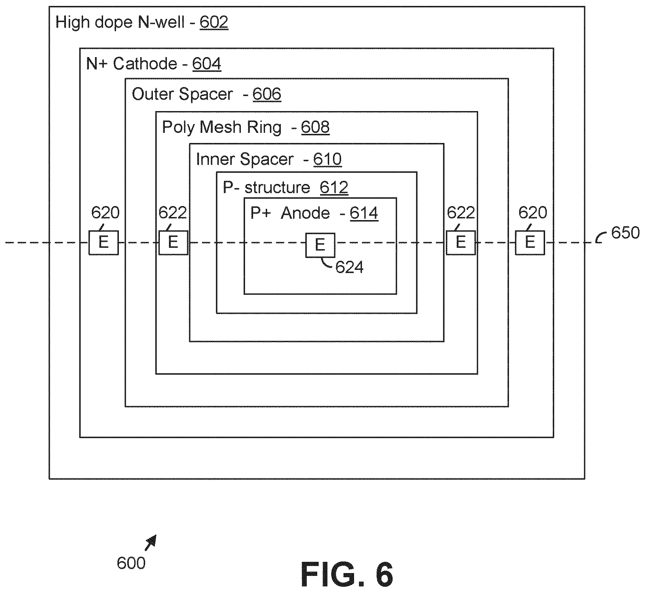

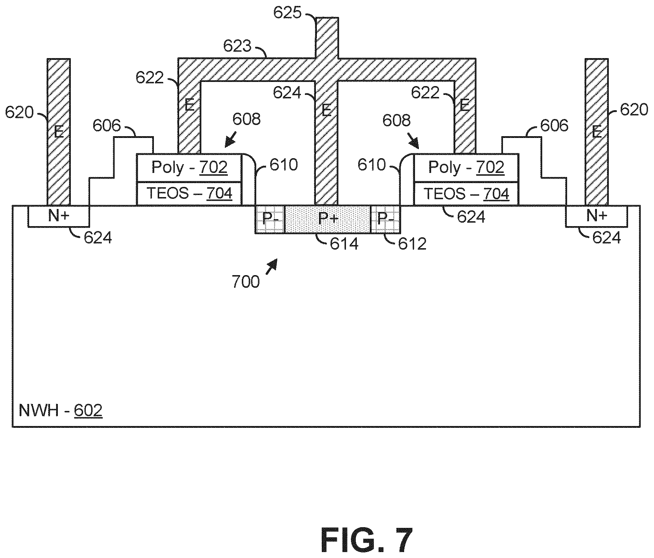

FIG. 6 is a diagrammatic top view of a Zener diode in accordance with embodiments of the present disclosure. FIG. 7 is a diagrammatic cut away side view of the Zener diode of FIG. 6 according to various embodiments of the present disclosure. The structure illustrated in FIG. 7 is taken along reference line 650 of FIG. 6.

Referring to both FIG. 6 and FIG. 7, the Zener diode 600 includes a Zener junction 700 formed in a semiconductor substrate, the Zener junction 700 including a P+ anode 614. The Zener diode 600 is formed in a high dope N-well 602 of the semiconductor substrate. The P+ anode 612 is formed in the high dope N-well 602 in an upper portion of the semiconductor substrate. The Zener diode 600 includes an N+ cathode 604 formed in the high dope N-well 602.

The Zener diode 600 further includes a poly mesh ring 608 formed on a surface of the semiconductor substrate and surrounding the P+ anode 614. The N+ cathode 604 is formed in the semiconductor substrate opposite the poly mesh ring 608 from the P+ anode 612. The Zener diode 600 further includes an outer spacer 606 formed on an outer portion of the poly mesh ring 608 between the N+ cathode 604 and the poly mesh ring 608. With the construct of the Zener diode 600, the N+ cathode 604 surrounds the poly mesh ring 608, separated from the poly mesh ring 608 by the outer spacer 606. The Zener diode 600 further includes a P- structure 612 formed in the high dope N-well 602 in an upper portion of the semiconductor substrate and adjacent and surrounding the P+ anode 614. The Zener diode further includes an inner spacer 610 formed on an inner portion of the poly mesh ring 608 adjacent to the P- structure 612.

With an optional construct of the illustrated embodiment, the width of the outer spacer 606 is greater than the width of the inner spacer 610. Further, with another optional construct of the Zener diode 600, the poly mesh ring 608 includes a polysilicon layer 702 residing upon a TEOS layer 704.

Moreover, with another optional construct of the Zener diode 600, the polysilicon layer 702 of the poly mesh ring 608 is electrically coupled to the P+ anode 612. In such construct(s) the Zener diode 600 includes a plurality of electrical connections 620, 622, 623, 624 and 625. These electrical connections are one or more of vias and metal traces formed in one or more metal routing layers of the semiconductor substrate (only 620, 622 and 624 shown in FIG. 6). Electrical connections 622 electrically coupled to and interconnecting the poly mesh ring 608 and P+ anode 612, providing electrical connectivity between the P+ anode 612 and the poly of the poly mesh ring 608, and providing an external electrical connection. This optional constructs provide additional reduction in the variation of the Zener breakdown voltage over time.

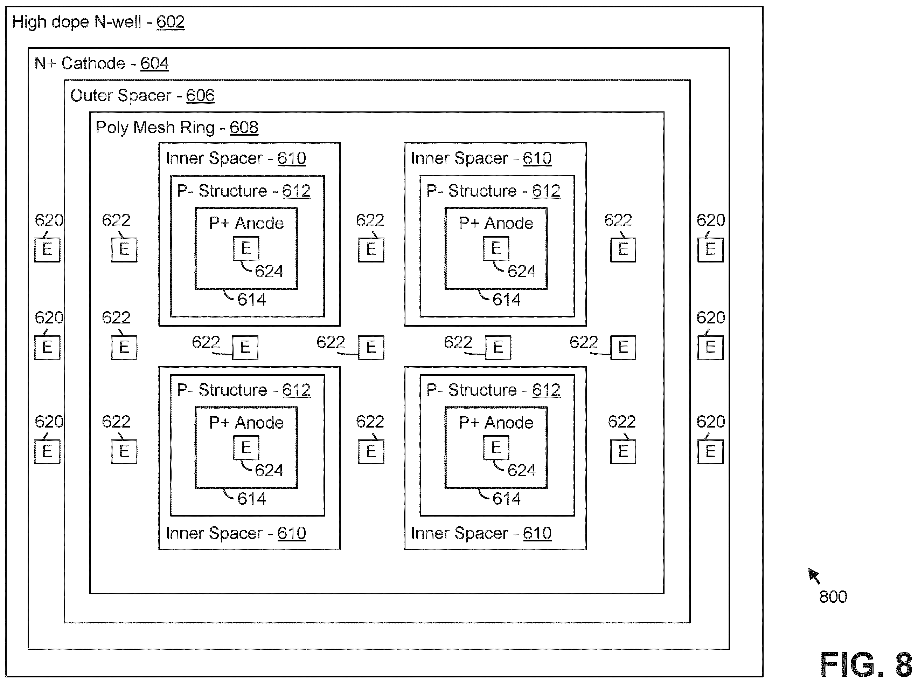

FIG. 8 is a diagrammatic top view of a Zener diode array in accordance with embodiments of the present disclosure consistent with FIGs. 6 and 7. The Zener diode array 800 includes a plurality of Zener junctions 700 formed in a semiconductor substrate as an array, each Zener junction including a P+ anode 614 formed in a high dope N-well 602 of the semiconductor substrate. The Zener diode array 800 further includes an N+ cathode 604 formed in the high dope N-well 602 of the semiconductor substrate. Each Zener diode further includes a P- structure 612 formed in the high dope N-well 602 in an upper portion of the semiconductor substrate and adjacent and surrounding the P+ anode 614.

Each of the Zener junctions 400 is consistent with FIGS. 6 and 7 as are other components of the Zener diode array 800. The Zener diode array 800 also includes a poly mesh ring 608 formed on a surface of the semiconductor substrate, the poly mesh ring 608 surrounding each of the plurality of Zener junctions 700. As is shown in FIG. 8., the N+ cathode 604 surrounds the poly mesh ring 608. The Zener diode array 800 further includes an outer spacer 606 formed on an outer portion of the poly mesh ring 608 isolating the poly mesh ring 608 from the N+ cathode 604. The Zener diode array 800 further includes a plurality of inner spacers 610, each inner spacer 610 formed on an inner portion of the poly mesh ring 608, surrounding and adjacent a respective P- structure 612.

With one construct of the Zener diode array, the poly mesh ring includes a polysilicon layer 702 residing upon a TEOS layer 704 and the polysilicon layer 702 is electrically coupled to at least one P+ anode 614. Refer to FIGs. 6 and 7 for the electrical connections for tying a P+ anode 614 to the polysilicon layer 702 and the construct of the electrical connections. The Zener diode array may be NxN array, where N is a positive integer or an NxM array, where each of N and M are positive integers.

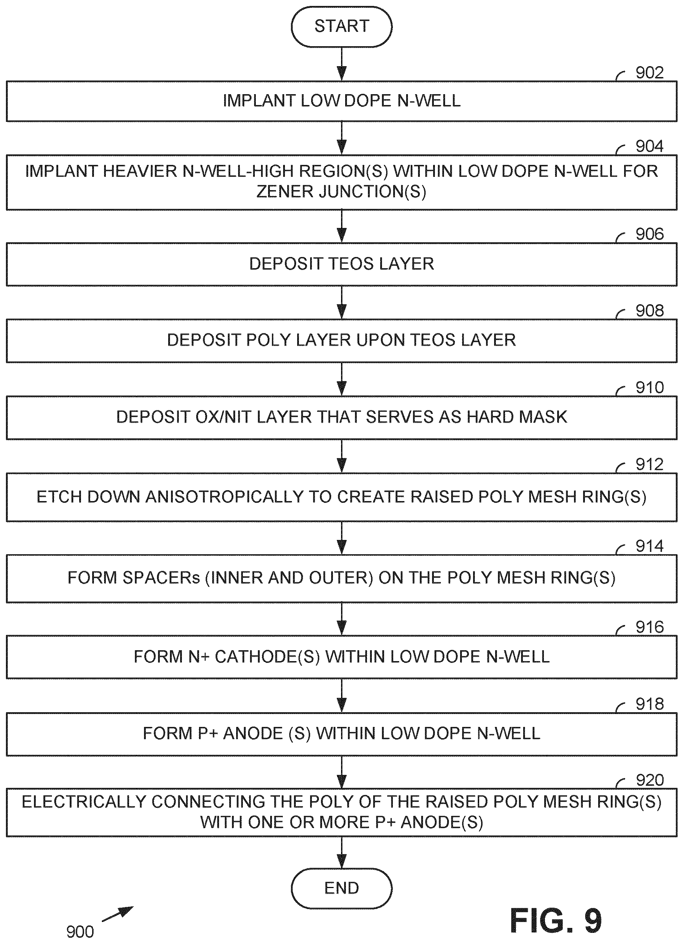

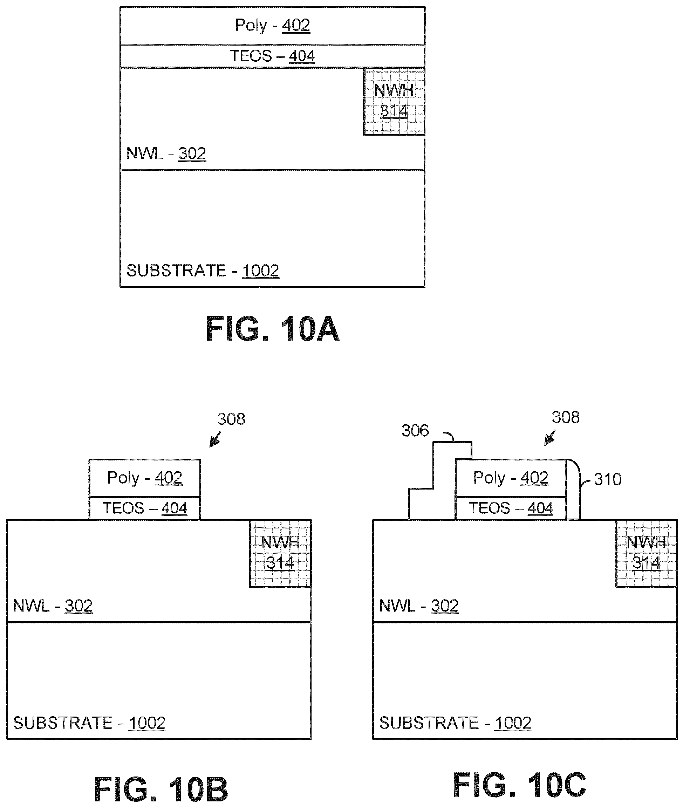

FIG. 9 is a flow chart illustrating a process for manufacturing a Zener diode of FIGs. 3 and 4 in accordance with various embodiments of the present disclosure. FIGs. 10A, 10B and 10C are diagrammatic cut away side views of a Zener diode at particular manufacturing process steps in accordance with various embodiments of the present disclosure and consistent with FIG. 9. Zener diodes formed using the operations of FIG. 9 are consistent with the Zener diode described with reference to FIGs. 3 and 4 and the Zener diode array 500 described with reference to FIG. 5. Additional manufacturing steps are not described in FIG. 9 but are well known at the time of filing of this disclosure.

References will be primarily made to FIG. 9 with reference to FIG. 10A, 10B and 10C during particular manufacturing stages of FIG. 9. The operations of FIG. 9 may be performed using conventional manufacturing techniques know at the time of filing of this disclosure. Operations 900 begin with implanting a low dope N-well 302 in a semiconductor substrate 1002 (step 902). Operations continue with implanting a heavier N-well high region 314 within the low dope N-well 302. Operations 900 continue with depositing a TEOS layer across some or all of the semiconductor substrate an area of the Zener diode (step 906). Operations 900 continue with depositing a poly layer upon the TEOS layer (step 908). After step 908 the structure formed is consistent with FIG. 10A.

Referring again to FIG. 9, operations 900 continue with depositing an oxide/nitride (OX/NIT) layer upon the poly layer and creating a hard mask by selectively removing portions of the OX/NIT layer (step 910). Operations then anisotropically etching the poly/TEOS to form the raised poly mesh ring(s) (step 912). After step 908 the structure formed is consistent with FIG. 10B.

Referring again to FIG. 9, operations 900 include forming an outer spacer 306 on an outer portion of the poly mesh ring 308 and an inner spacer 310 on an inner portion of the poly mesh ring (step 914). Step 914 may be performed such that the width of the outer spacer is greater than the width of the inner spacer. After step 914 the structure formed is consistent with FIG. 10C.

Referring again to FIG. 9, operations 900 include forming N+ cathode(s) 304 in the low dope N-well 302 in an area surrounding the outer spacer (step 916). Referring again to FIG. 9, operations 900 include forming the P+ anode(s) 314 within the N-well high region(s) 314 (step 918). Finally, operations include electrically connecting the poly of the raised poly mesh ring(s) with one or more P+ anode(s) (step 920).

The operations 900 may be performed such that the width of the outer spacer is greater than the width of the inner spacer. Further, the operations 900 may include electrically coupling the P+ anode with the poly mesh ring.

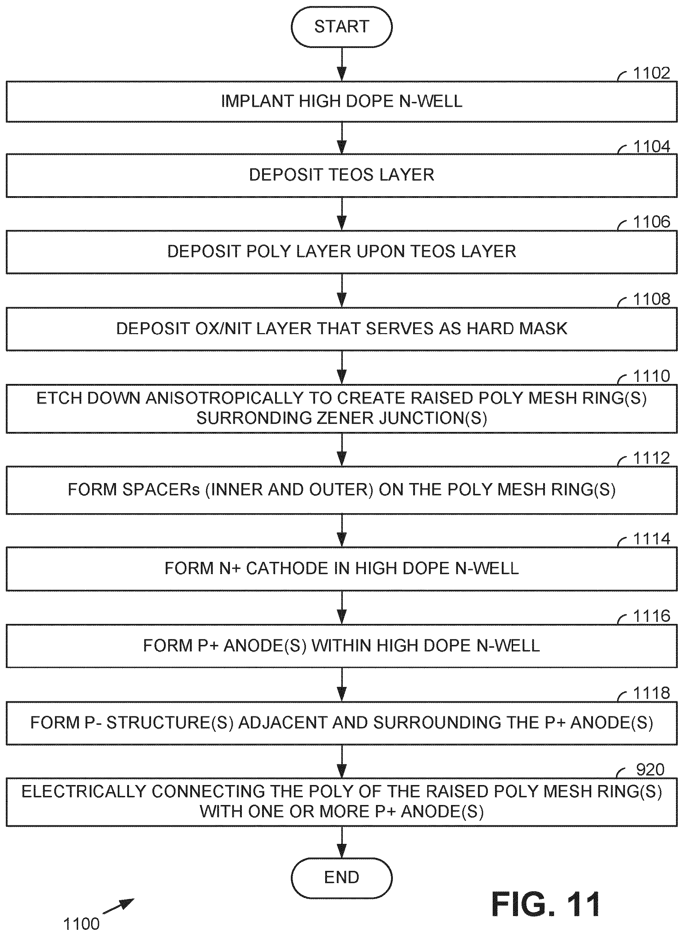

FIG. 11 is a flow chart illustrating a process for manufacturing a Zener diode of FIGs. 6 and 7 in accordance with various embodiments of the present disclosure. Zener diodes formed using the operations of FIG. 11 are consistent with the Zener diode described with reference to FIGs. 6 and 7 and the Zener diode array described with reference to FIG. 8. Additional manufacturing steps are not described in FIG. 11 but are known to the reader. The operations 1100 may be performed using conventional manufacturing techniques known at the time of filing of this disclosure.

Operations 1100 begin with implanting a high dope N-well 602 in a semiconductor substrate (step 1102). Operations 1100 continue with depositing a TEOS layer across some or all of the semiconductor substrate an area of the Zener diode (step 1104). Operations 1100 continue with depositing a poly layer upon the TEOS layer (step 1106). Operations 1100 continue with depositing an OX/NIT layer upon the poly layer and creating a hard mask by selectively removing portions of the OX/NIT layer (step 1108). Operations 100 then include anisotropically etching the poly/TEOS layers to form the raised poly mesh ring(s) (step 1110). Operations 1100 next include forming an outer spacer on an outer portion of the poly mesh ring and an inner spacer on an inner portion of the poly mesh ring (step 1112). Step 1112 may be performed such that the width of the outer spacer is greater than the width of the inner spacer.

Operations 1100 conclude with forming an N+ cathode 604 in the high dope N-well 602 in an area surrounding the outer spacer (step 1114). Operations 1100 next include forming P+ anode(s) 614 within the high dope N-well 602 (step 1116). Operations then include forming P- structure(s) in the high dope N-well in an upper portion of the semiconductor substrate and adjacent and surrounding the P+ anode(s) (step 1118). The reader will appreciate that steps 1114, 1116, and 1118 could be performed in a differing order than illustrated. Finally, operations may include electrically connecting the poly of the raised poly mesh ring(s) with one or more P+ anode(s) (step 920).

With the previously described embodiments, physical ranges may be as follows:

- 

$$\text{TEOS thickness} = 200A \text{ (Angstroms)} - 1u \text{ (micron)}$$

- 

$$\text{N-well low doping} = 1e15 - 1e17 \text{ /cm3 concentration}$$

- 

$$\text{N-well high doping} = 1e18 - 1e19 \text{ /cm3 concentration}$$

- 

$$\text{N+/P+ doping} = 1e19 - 1e21 \text{ /cm3 concentration}$$

- 

$$\text{Poly-Poly spacing} = 0.6u - 2u$$

- 

$$\text{Poly-N-well high spacing} = 0.1 - 0.4 \text{ um (micrometer)}$$

- 

$$\text{Poly ring width} = 0.2 - 1 \text{ um}$$

In accordance with a first aspect of the present disclosure, a Zener diode includes a Zener junction formed in a semiconductor substrate, the Zener junction including a P+ anode, a poly mesh ring formed on a surface of the semiconductor substrate and surrounding the P+ anode, an N+ cathode formed in the semiconductor substrate opposite the poly mesh ring from the P+ anode, an outer spacer formed on an outer portion of the poly mesh ring between the N+ cathode and the poly mesh ring, and an inner spacer formed on an inner portion of the poly mesh ring adjacent to the P+ anode.

The width of the outer spacer may be greater than the width of the inner spacer. The poly mesh ring may be a polysilicon layer residing upon a Tetraethyl Orthosilicate (TEOS) layer and the polysilicon layer may be electrically coupled to the P+ anode. The N+ cathode may surround the poly mesh ring.

The Zener diode may be formed in a low dope N-well of the semiconductor substrate with the Zener junction including a N-well high region formed in the low dope N-well, adjacent and below the P+ anode. The Zener diode may be formed in a high dope N-well of the semiconductor substrate and the Zener junction may include a P- structure formed in the high dope N-well in an upper portion of the semiconductor substrate and adjacent and surrounding the P+ anode.

In accordance with a second aspect of the present disclosure, a Zener diode array includes a plurality of Zener junctions formed in a semiconductor substrate as an array, each Zener junction including a P+ anode, a poly mesh ring formed on a surface of the semiconductor substrate, the poly mesh ring surrounding each of the plurality of Zener junctions, an N+ cathode formed in the semiconductor substrate opposite the poly mesh ring from the P+ anodes, an outer spacer formed on an outer portion of the poly mesh ring isolating the poly mesh ring from the N+ cathode, and a plurality of inner spacers, each inner spacer formed on an inner portion of the poly mesh ring, surrounding and adjacent a respective P+ anode.

The width of the outer spacer may be greater than the width of each of the plurality of inner spacers. The poly mesh ring may be a polysilicon layer residing upon a Tetraethyl Orthosilicate (TEOS) layer and the polysilicon layer may be electrically coupled to at least one anode. The N+ cathode may surround the poly mesh ring.

The Zener diode array may be an NxN array, where N is a positive integer. The Zener diode array may be an NxM array, where each of N and M are positive integers.

The Zener diode array may be formed in a low dope N-well of the semiconductor substrate with each Zener junction including an N-well high region formed in the low dope N-well, adjacent and below the P+ anode.

The Zener diode array may be formed in a high dope N-well of the semiconductor substrate with each Zener junction including a P- structure formed in the high dope N-well in an upper portion of the semiconductor substrate and adjacent and surrounding the P+ anode, and the N+ cathode being an N+ region formed in the high dope N-well.

In accordance with a third aspect of the present disclosure, a method for forming a Zener diode having a Zener junction in a semiconductor substrate, the method includes implanting an N-well in the semiconductor substrate, forming a poly mesh ring on a surface of the semiconductor substrate, forming an outer spacer on an outer portion of the poly mesh ring, forming an inner spacer on an inner portion of the poly mesh ring, forming an N+ cathode in the N-well surrounding the outer spacer, and forming a Zener junction in the semiconductor substrate within the inner spacer, the Zener junction including a P+ anode.

The width of the outer spacer may be greater than the width of the inner spacer. The poly mesh ring may be a polysilicon layer residing upon a Tetraethyl Orthosilicate (TEOS) layer.

The N-well may be a low dope N-well with the Zener junction including a P+ anode formed in the low dope N-well in an upper portion of the semiconductor substrate, and a N-well high region formed in the low dope N-well, adjacent and below the P+ anode.

The N-well may be a high dope N-well with the Zener junction including a P+ anode formed in the high dope N-well in an upper portion of the semiconductor substrate and a P- structure formed in the high dope N-well in an upper portion of the semiconductor substrate and adjacent and surrounding the P+ anode.

The method may include electrically coupling the P+ anode with the poly mesh ring.

One or more embodiments have been described above with the aid of method steps. The boundaries and sequence of these method steps have been defined herein for convenience of description. Alternate boundaries and sequences can be defined so long as the specified functions and relationships are appropriately performed. Any such alternate boundaries or sequences are thus within the scope and spirit of the claims. To the extent used, the flow chart block boundaries and sequence could have been defined otherwise and still perform the certain significant functionality. Such alternate definitions of flow chart blocks and sequences are thus within the scope and spirit of the claims.

In addition, a flow chart may include a "start" and/or "end" indication. The "start" indication reflects that the steps presented can optionally be incorporated in or otherwise used in conjunction with one or more other routines. The "end" indication reflects that the steps presented can end as described and shown or optionally be incorporated in or otherwise used in conjunction with one or more other routines. In this context, "start" indicates the beginning of the first step presented and may be preceded by other activities not specifically shown. Further, while a flow chart indicates a particular ordering of steps, other orderings are likewise possible provided that the principles of causality are maintained.

The one or more embodiments are used herein to illustrate one or more aspects, one or more features, one or more concepts, and/or one or more examples. A physical embodiment of an apparatus, an article of manufacture, a machine, and/or of a process may include one or more of the aspects, features, concepts, examples, etc. described with reference to one or more of the embodiments discussed herein. Further, from figure to figure, the embodiments may incorporate the same or similarly named functions, steps, modules, etc. that may use the same or different reference numbers and, as such, the functions, steps, modules, etc. may be the same or similar functions, steps, modules, etc. or different ones.

While particular combinations of various functions and features of the one or more embodiments have been expressly described herein, other combinations of these features and functions are likewise possible. The present disclosure is not limited by the particular examples disclosed herein and expressly incorporates these other combinations.

## Claims

1. A Zener diode comprising:

   a Zener junction formed in a semiconductor substrate, the Zener junction including a P+ anode;
   a poly mesh ring formed on a surface of the semiconductor substrate and surrounding the P+ anode;
   an N+ cathode formed in the semiconductor substrate opposite the poly mesh ring from the P+ anode;
   an outer spacer formed on an outer portion of the poly mesh ring between the N+ cathode and the poly mesh ring; and

an inner spacer formed on an inner portion of the poly mesh ring adjacent to the P+ anode.

2. The Zener diode of claim 1, wherein the width of the outer spacer is greater than the width of the inner spacer.

3. The Zener diode of claim 1 or 2, wherein:

the poly mesh ring comprises a polysilicon layer residing upon a Tetraethyl Orthosilicate (TEOS) layer; and
the polysilicon layer is electrically coupled to the P+ anode.

4. The Zener diode of any preceding claim, wherein the N+ cathode surrounds the poly mesh ring.

5. The Zener diode of any preceding claim, wherein:

the Zener diode is formed in a low dope N-well of the semiconductor substrate; and
the Zener junction includes a N-well high region formed in the low dope N-well, adjacent and below the P+ anode.

6. The Zener diode of any one of claims 1 to 4, wherein:

the Zener diode is formed in a high dope N-well of the semiconductor substrate; and
the Zener junction includes a P- structure formed in the high dope N-well in an upper portion of the semiconductor substrate and adjacent and surrounding the P+ anode.

7. A method for forming a Zener diode having a Zener junction in a semiconductor substrate, the method comprising:

implanting an N-well in the semiconductor substrate;
forming a poly mesh ring on a surface of the semiconductor substrate;
forming an outer spacer on an outer portion of the poly mesh ring;
forming an inner spacer on an inner portion of the poly mesh ring;
forming an N+ cathode in the N-well surrounding the outer spacer; and
forming a Zener junction in the semiconductor substrate within the inner spacer, the Zener junction including a P+ anode.

8. The method of claim 7, wherein the width of the outer spacer is greater than the width of the inner spacer.

9. The method of claim 7 or 8, wherein the poly mesh ring comprises a polysilicon layer residing upon a Tetraethyl Orthosilicate (TEOS) layer.

10. The method of any one of claims 7 to 9, wherein:

the N-well is a low dope N-well; and
the Zener junction includes an N-well high region formed in the low dope N-well, adjacent and below the P+ anode.

11. The method of any one of claims 7 to 9, wherein:

the N-well is a high dope N-well; and
the Zener junction includes:

the P+ anode formed in the high dope N-well in an upper portion of the semiconductor substrate; and
a P- structure formed in the high dope N-well in the upper portion of the semiconductor substrate and adjacent and surrounding the P+ anode.

12. The method of any one of claims 7 to 11, further comprising electrically coupling the P+ anode with the poly mesh ring.

EP 4 718 975 A1

**Integrated Circuit** 100

**Digital Circuitry** 102

**Analog Circuitry** 104

**Voltage Reference Circuitry** 106

**Zener Diode(s)** 108

**FIG. 1**

256 254 252

208

T0 Spread

After Soldering

After Soldering and Aging

250

**FIG. 2B**

202A AALS

202B AALS

202C AALS

201

204 ADC

ADC Code

208 DSP

206 Voltage reference Circuitry

200

**FIG. 2A**

Low dope N-well - 302

N+ Cathode - 304

Outer Spacer - 306

Poly Mesh Ring - 308

Inner Spacer - 310

P+ Anode - 312

⌐ 314

320    322    N Well High    322    320

E      E      E              E      E    ⌐ 350

⌐ 324

300 ↗

**FIG. 3**

FIG. 4

EP 4 718 975 A1

Low dope N-well - 302

N+ Cathode - 304

Outer Spacer - 306

Poly Mesh Ring - 308

Inner Spacer - 310

P+ Anode - 312

N Well High

E
324
314

Inner Spacer - 310

P+ Anode - 312

N Well High

E
324
314

320
E

322
E

322
E

322
E

320
E

320
E

322
E

322
E

322
E

322
E

320
E

322
E

322
E

322
E

320
E

322
E

322
E

322
E

320
E

Inner Spacer - 310

P+ Anode - 312

N Well High

E
324
314

Inner Spacer - 310

P+ Anode - 312

N Well High

E
324
314

500

**FIG. 5**

High dope N-well - 602

N+ Cathode - 604

Outer Spacer - 606

Poly Mesh Ring - 608

Inner Spacer - 610

P- structure 612

P+ Anode - 614

620   622   622   620

E   E   E   E   E

624

650

600

**FIG. 6**

FIG. 7

FIG. 8

800

START

↓ 902

IMPLANT LOW DOPE N-WELL

↓ 904

IMPLANT HEAVIER N-WELL-HIGH REGION(S) WITHIN LOW DOPE N-WELL FOR ZENER JUNCTION(S)

↓ 906

DEPOSIT TEOS LAYER

↓ 908

DEPOSIT POLY LAYER UPON TEOS LAYER

↓ 910

DEPOSIT OX/NIT LAYER THAT SERVES AS HARD MASK

↓ 912

ETCH DOWN ANISOTROPICALLY TO CREATE RAISED POLY MESH RING(S)

↓ 914

FORM SPACERs (INNER AND OUTER) ON THE POLY MESH RING(S)

↓ 916

FORM N+ CATHODE(S) WITHIN LOW DOPE N-WELL

↓ 918

FORM P+ ANODE (S) WITHIN LOW DOPE N-WELL

↓ 920

ELECTRICALLY CONNECTING THE POLY OF THE RAISED POLY MESH RING(S) WITH ONE OR MORE P+ ANODE(S)

↓

END

900

FIG. 9

Poly - 402

TEOS – 404

NWH
314

NWL - 302

SUBSTRATE - 1002

## FIG. 10A

308

Poly - 402

TEOS – 404

NWH
314

NWL - 302

SUBSTRATE - 1002

## FIG. 10B

306

308

Poly - 402

310

TEOS – 404

NWH
314

NWL - 302

SUBSTRATE - 1002

## FIG. 10C

START

1102
IMPLANT HIGH DOPE N-WELL

1104
DEPOSIT TEOS LAYER

1106
DEPOSIT POLY LAYER UPON TEOS LAYER

1108
DEPOSIT OX/NIT LAYER THAT SERVES AS HARD MASK

1110
ETCH DOWN ANISOTROPICALLY TO CREATE RAISED POLY MESH RING(S) SURRONDING ZENER JUNCTION(S)

1112
FORM SPACERs (INNER AND OUTER) ON THE POLY MESH RING(S)

1114
FORM N+ CATHODE IN HIGH DOPE N-WELL

1116
FORM P+ ANODE(S) WITHIN HIGH DOPE N-WELL

1118
FORM P- STRUCTURE(S) ADJACENT AND SURROUNDING THE P+ ANODE(S)

920
ELECTRICALLY CONNECTING THE POLY OF THE RAISED POLY MESH RING(S) WITH ONE OR MORE P+ ANODE(S)

END

1100

# FIG. 11

Europäisches
Patentamt

European
Patent Office

Office européen
des brevets

## EUROPEAN SEARCH REPORT

**Application Number**

EP 25 20 4912

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 869 882 A (CHEN WAYNE T [US] ET AL) 9 February 1999 (1999-02-09) * Fig. 1, 2, 5 and 6 and correlated description * | 1,2,4-8, 10-12 | INV. H10D8/01 H10D8/25 H10D62/10 H10D64/00 |
| X | US 2015/333189 A1 (CHEN WEIZE [US] ET AL) 19 November 2015 (2015-11-19) * Fig. 2-9 and 16 and correlated description * | 1-5, 7-10,12 | |
| A | US 5 486 486 A (GHEZZI PAOLO [IT] ET AL) 23 January 1996 (1996-01-23) * the whole document * | 5,10 | |
| A | US 2019/081040 A1 (KANAYA TOSHIYUKI [JP] ET AL) 14 March 2019 (2019-03-14) * the whole document * | 6,11 | |

**TECHNICAL FIELDS SEARCHED (IPC)**

H10D

The present search report has been drawn up for all claims

| Place of search | Date of completion of the search | Examiner |
|---|---|---|
| Munich | 5 February 2026 | Melodia, Andrea |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 20 4912

This annex lists the patent family members relating to the patent documents cited in the above-mentioned European search report.
The members are as contained in the European Patent Office EDP file on
The European Patent Office is in no way liable for these particulars which are merely given for the purpose of information.

05-02-2026

| Patent document cited in search report | | Publication date | Patent family member(s) | | Publication date |
|---|---|---|---|---|---|
| US 5869882 | A | 09-02-1999 | JP | 4278721 B2 | 17-06-2009 |
| | | | JP | H08181334 A | 12-07-1996 |
| | | | US | 5869882 A | 09-02-1999 |
| US 2015333189 | A1 | 19-11-2015 | US | 2015162417 A1 | 11-06-2015 |
| | | | US | 2015333189 A1 | 19-11-2015 |
| US 5486486 | A | 23-01-1996 | DE | 69322384 T2 | 12-05-1999 |
| | | | EP | 0643418 A1 | 15-03-1995 |
| | | | JP | H07106604 A | 21-04-1995 |
| | | | US | 5486486 A | 23-01-1996 |
| | | | US | 5600590 A | 04-02-1997 |
| US 2019081040 | A1 | 14-03-2019 | NONE | | |

EPO FORM P0459

For more details about this annex : see Official Journal of the European Patent Office, No. 12/82